(19) Europäisches Patentamt
European Patent Office
Office européen des brevets

(11) **EP 3 279 365 A1**

(12) **EUROPEAN PATENT APPLICATION**
published in accordance with Art. 153(4) EPC

(43) Date of publication:
**07.02.2018 Bulletin 2018/06**

(21) Application number: **16771450.0**

(22) Date of filing: **30.03.2016**

(51) Int Cl.:
**C23C 14/34** $^{(2006.01)}$    **C23C 14/28** $^{(2006.01)}$

(86) International application number:
**PCT/ES2016/070220**

(87) International publication number:
**WO 2016/156649 (06.10.2016 Gazette 2016/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **31.03.2015 ES 201530440**

(71) Applicant: **Advanced Nanotechonologies, S.L.
08028 Barcelona (ES)**

(72) Inventors:
• **BERTRÁN SERRA, Enric**
  **08028 Barcelona (ES)**
• **AMADE ROVIRA, Roger**
  **08028 Barcelona (ES)**

(74) Representative: **Balder IP Law, S.L.
Paseo de la Castellana 93
5a planta
28046 Madrid (ES)**

(54) **PERISHABLE ELEMENT FOR PARTICLE BOMBARDMENT, SET OF DEVICES FOR PARTICLE BOMBARDMENT AND PERISHABLE ELEMENT AND METHOD FOR DETERMINING THE ETCHING PATTERN VIA PARTICLE BOMBARDMENT OF A TARGET**

(57)     Fungible element (1) provided with a target (2) for particle bombardment, intended to carry out the vapour-phase physical deposition of a thin layer on a substrate (3), said fungible element (1) comprising a base layer (4) on which the target (2) is deposited, said target intended to be sputtered by the particle bombardment, wherein the target is formed by at least one layer (21) in which a plurality of zones $(x_i, y_i)$ is defined, having an average thickness $(e_j(x_i, y_i))$ that is variable between the zones $(x_i, y_i)$, said average thicknesses $(e_j(x_i, y_i))$ of each zone $(x_i, y_i)$ being dimensioned such that, in certain bombardment conditions, all the zones $(x_i, y_i)$ have an identical ion sputtering time $(t_j)$. The invention also refers to a particle bombardment device (5) and fungible element (1) set and to the process to obtain such fungible element (1).

Fig. 8

EP 3 279 365 A1

# Description

## Technical field

The present invention is framed in the thin film coatings sector, particularly achieved by particle bombardment.

## Background of the invention

Well known are the vapour-phase physical deposition tecniques for substrate thin film coating, consisting of bombarding a target with particles such as ions or photons, so that this target emits the coating particles (consisting of isolated atoms or few atoms clusters) that are transfered to the substrate to be coated.

To perform such coatings the process consists of setting a substrate in front of a particle source, estimating the appropriate amount of time needed to achieve a certain coating thickness and bombarding during a certain amount of time. The resulting coating thickness is highly dependent on bombardment time and therefore a very precise control of the bombardment time is essential to obtain the desired results

In other cases, more complex coatings might be desired, i.e. different coating materials or a multilayer coating. In such cases, different material targets must be placed sequentially, and likewise control bombardment times with precision, in order to achieve the desired coatings.

These are usual laboratory tasks and can be performed with satisfactory results. But, if the objective is to perform coatings on an industrial scale in order to market the coated products on a large scale, the aforementioned process can result in excessively expensive costs, especially if a high end quality is pursued.

Particularly, the uniformity of results will strongly depend of every facility, and especially much dependent on the control performed by the bombardment facility operator.

For this reason, the inventors reached the conclusion that there is a lack of solutions to reduce coating costs and guarantee an optimal coating quality at the same time, and very much especifically allow the dependancy reduction of a proper coating on bombardment time precision.

## Description of the invention

To achieve that, the current invention proposes a fungible element provided with a target for the particle bombardment, intended to carry out the vapour-phase physical deposition of a thin layer on a substrate, said fungible element comprising a base layer on which the target is deposited, said target intended to be sputtered by the particle bombardment, wherein the target is formed by at least one layer $(j)$ in which a plurality of zones $(x_i, y_i)$ is defined, having an average thickness $(e_j(x_i, y_i))$ that is variable between the zones $(x_i, y_i)$, said average thicknesses $(e_j(x_i, y_i))$ of each zone $(x_i, y_i)$ being dimensioned such that, for determined bombardment conditions, all the zones $(x_i, y_i)$ have an identical ion sputtering time $(t_j)$.

In this way it is possible to overcome the disadvantages of the state of the art. In fact, this fungible element allows the coating thickness to be dependent of a previously prepared element, instead of being totally dependent on real time parameter adjusting tasks performed by an operator. This allows coating stage industrialization of any coating type, either mono layer or multilayer, in any process using particle bombardment targets.

Thus the invention allows to eliminate the necessity to control both bombardment time and source power (assuming that the source footprint does not vary significantly with the power variation) to obtain neat interface multilayer structures, that is to say separation surfaces between different coating layers. The fungible element can be employed to produce optical interference multilayer deposition, mono layer or multilayer electric contact metallization, ultrathin monolayer or multilayer structures -down to monoatomic thicknesses-, nano-island or nano-structure controlled deposits on a substrate, a previous stage to coalescence, among others.

The target will preferably be constituted by a plurality of layers.

Advantageously, the different $(x_i, y_i)$ zones can be formed by the same material or by different materials.

The invention also refers to a set formed by a particle bombardment device and a fungible element provided with a target to be bombarded (with ions, neutral particles or photons) by the said particle bombardment device intended to carry out the vapour-phase physical deposition of a thin layer on a substrate intended to receive the deposition material disposed on the target, said fungible element comprising a base layer on which the target is deposited, said target intended to be sputtered by the particle bombardment, wherein the target is formed by at least one layer in which a plurality of zones $(x_i, y_i)$ is defined, having an average thickness $(e_j(x_i, y_i))$ that is variable between the zones $(x_i, y_i)$, said average thicknesses $(e_j(x_i, y_i))$ of each zone $(x_i, y_i)$ being dimensioned such that, in certain bombardment conditions, all the zones $(x_i, y_i)$ have an identical ion sputtering time $(t_j)$, so that it is possible to control the thickness of the layer deposited on the substrate by the previous dimensioning of the target deposition material thicknesses $(e_j(x_i, y_i))$.

The target of the set will preferably be constituted by a plurality of layers.

Advantageously, in the set, the different $(x_i, y_i)$ zones can be formed by the same material or by different materials.

As a variant, in the set, the bombardment is an ionic bombardment, i.e. performed by means of cathodic sputtering head or ion gun as well as neutral particle bombardment by means of a neutralized ion gun or plasma gun or similar techniques.

As another variant, in the set, in which the bombardment is a photonic bombardment in order to produce laser ablation (LAD) or photonic bombardment by means of pulsed laser (PLD) or by means of similar techniques.

Preferably, in the set, the head or gun comprises the means for changing its orientation so it is possible to orient it towards the target as well as the substrate, thus having the possibility of commuting between an ion or plasma gun assisted deposition mode and a compaction by direct bombardment mode.

The invention also refers to a process for the determination of an engraving pattern by target (2) particles bombardment, in order to obtain an engraving velocity and thickness $(e_j(x_i, y_i))$ based on the position $(x, y)$ of a fungible element according to any of the aforementioned fungible element variations, comprising the stages of:

a) Performing an homogeneous deposit of deposition material on a base layer to obtain an homogeneous thickness target;

b) Arranging on the target a resin mask, so that there are zones of the target that remain covered by the resin as well as zones that remain uncovered by the resin;

c) Arranging the resulting product during a certain amount of time, in a certain position and in front of a certain particle bombardment device to perform a vapour-phase physical deposition process of a thin layer on a substrate;

d) Removing the resin mask;

e) Measuring the local height differences between target resin covered points and non resin covered points;

f) Obtaining an engraving velocity function $v_j(x_i, y_i)$ of the target for the aforementioned certain conditions;

g) Using the said engraving velocity function $v_j(x_i, y_i)$ to determine the thickness $(e_j(x_i, y_i))$ of the target in every position $(x,y)$ so that the layer or layers $(j)$ of the fungible element can be consumed one after another.

Preferably, in the inventivion process, the mask is a mesh.

Multilayer target fabrication can be performed by means of ink injection printers or *printjet* printers. These printers allow to reproduce point by point the thickness function $e_j(x_i, y_i)$ determined by means of the current invention process. The resolution is approximately 20 nm, that is the dried ink drop approximate thickness. This technique also allows to perform diverse materials mixtures and the production of expected thickness distribution $e_j(x_i, y_i)$ multilayer sets.

Once fabricated, these targets already contain all the necessary information to render the multilayer structures on many substrates, i.e. ophthalmic lenses and contact lenses, flat devices, interferential filters, multilayer coatings, gradient optical coatings, among others, and it is only needed to transfer the material, previously deposited on the target, to the corresponding substrate by means of an ionic bombardment, bombardment with ionic particles, bombardment with neutral particles or photonic bombardment or laser beam.

Advantageously, this deposition method allows controlling the deposition velocity in a very precise way and, specifically, control the deposited layers nucleation and coalescence phases evolution. This allows depositing nanometric structures and/or single atom or few atom or molecule sized thickness structures on a surface.

Depending on the substrate nature and on its surface energy, this method allows the deposition of nanometric structures or few atom clusters scattered over the substrate, according to the nucleation and growth models described by:

1. Frank van der Merwe (layer by layer growth)

2. Wolmer-Weber (island growth)

3. Stranski-Krastanov (island and layers combined growth)

This deposition method can also be used in *layer-by-layer* deposition processes and/or as a new modality in epitaxial growth processes like the ones used in MBE (molecular beam epitaxy).

## Brief description of the drawings

In order to complement the description and with the intention of helping to a better understanding of the invention features, according to an example of practical embodiment of the said invention, a set of figures wherein, for illustrative and non-limitative purposes, is attached as a description part and parcel, in which the following has been represented:

Figure 1 depicts a plan view of a target, with an example of mesh.

Figures 2 to 7 are different examples of fungible element layer structures.

Figure 8 is a particle bombardment installation.

Figures 9a to 9d depict the different stages for desired thicknesses determination for each target zone.

Figure 10a depicts a stratified target intended for the application of a target structure determination optical process.

Figure 10b depicts a device intended to obtain target thicknesses.

Figure 11a depicts components for the invention fungible element fabrication.

Figure 11b depicts a section cut of an installation for the fabrication of the invention fungible element.

## Description of preferred embodiments

As can be appreciated in the figures, the invention refers to a fungible element 1 provided with a target 2 for the particle bombardment, intended to carry out the vapour-phase physical deposition of a thin layer on a substrate 3, said fungible element 1 comprising a base layer 4 on which the target 2 is deposited, said target intended to be sputtered by the particle bombardment, wherein the target is formed by at least one layer 21 in which a plurality of zones $(xi, y_i)$ is defined, having an average thickness $(e_j(x_i, y_i))$ that is variable between the zones $(x_i, y_i)$, said average thicknesses $(e_j(x_i, y_i))$ of each zone $(xi, y_i)$ being dimensioned such that, in certain bombardment conditions, all the zones $(x_i, y_i)$ have an identical ion sputtering time $(t_j)$.

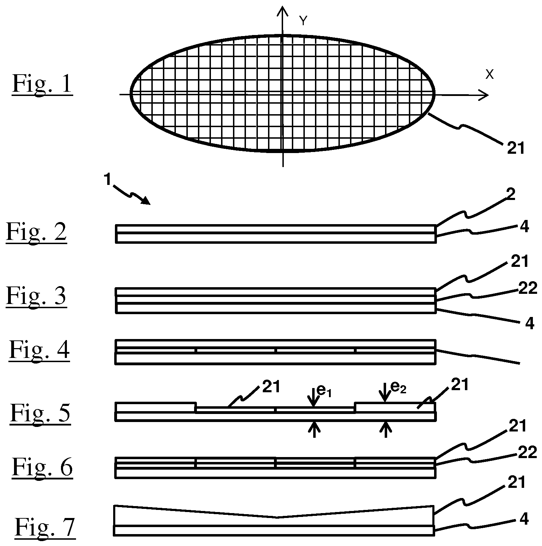

This is illustrated in a very simplified way in figure 5. Here one can appreciate two different thickness zones $e_1$ and $e_2$, which are submitted to different bombardment intensities. The element has been depicted in a convex shape, although it is not necessary to be shaped like this, for it will depend on the source yield distribution and the target yield distribution.

Another resulting distribution could be the one showed in figure 7. In some cases, especially when symmetries can be found in the installation different components and in the relative disposition between them, thickness distribution on the target will be approximate using a curve or a simple surface.

As can be appreciated in figures 3, 4 and 6, the target is formed by a plurality of layers 21, 22. Layers can be homogeneous as depicted in figures 2 and 3, or heterogeneous as well as depicted in figures 4 and 5.

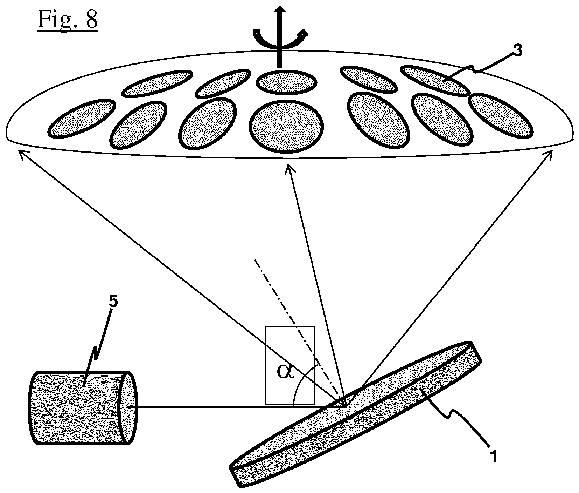

The invention, as illustrated in figure 8, also refers to a set formed by particle bombardment device 5 and fungible element 1 provided with a target 2 to be bombarded (with ions, neutral particles or photons) by the particle bombardment device 5 to perform vapour-phase physical deposition of a thin layer on a substrate 3 bound to receive the deposition material disposed on the target 2, said fungible element 1 comprising a base layer 4 on which said target 2 is deposited, characterized by the fact that said target 2 is constituted by at least one layer 21 in which a plurality of zones $(x_i, y_i)$ with an average thickness $(e_j(x_i, y_i))$ that is variable between the zones $(xi, y_i)$, said average thicknesses $(e_j(x_i, y_i))$ of each zone $(x_i, y_i)$ being dimensioned such that, in certain bombardment conditions, all the zones $(x_i, y_i)$ have an identical ion sputtering time $(t_j)$, being so that the thickness of the layer deposited on said substrate 3 can be controlled by the previous sizing of the target 2 deposition material thicknesses $(e_j(x_i, y_i))$.

The bombardment is an ionic bombardment performed by means of a cathodic sputtering head or a plasma ion gun as well as a bombardment of neutral particles by means of a neutralized ion gun or a plasma gun. The bombardment can also be a photonic bombardment in order to produce laser ablation (LAD) or photonic bombardment by means of pulsed laser (PLD).

As an advantageous option, the head or gun 5 comprises the means for changing its orientation so it is possible to orient it towards the target as well as the substrate, thus having the possibility of commuting between an ion or plasma gun assisted deposition mode and a compaction by direct bombardment mode.

The invention also refers to a process for the determination of an engraving pattern by target 2 particles bombardment, in order to obtain an engraving velocity and thickness $(e_j(x_i, y_i))$ based on the position $(x, y)$ of a fungible element 1 according to any of the variants depicted in figures 1 to 7, comprising the stages of:

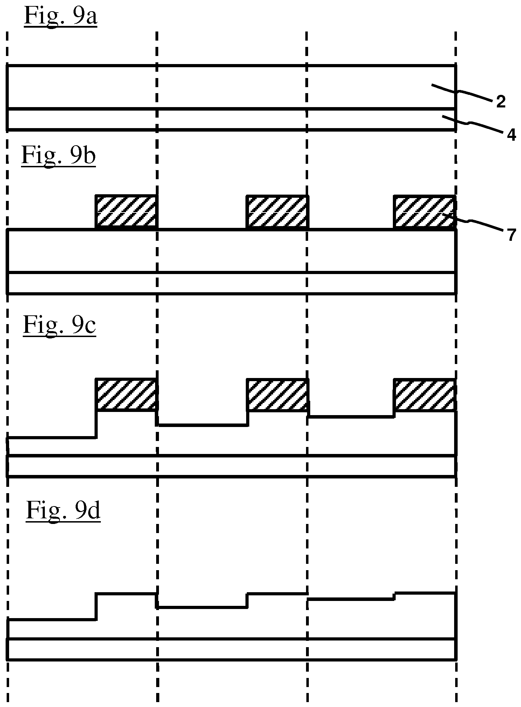

a) Perform an homogeneous deposit of deposition material on a base layer 4 to obtain a known $e_0$ homogeneous thickness target 2, as shown in figure 9a;

b) Dispose on the target 2 a resin mask 6, as depicted like a mesh in figure 1, so that there are zones of the target 2 that remain covered by the resin as well as zones that remain uncovered by the resin 7, as shown in figure 9b;

c) Dispose the resulting product during a certain amount of time, in a certain position and in front of a certain particle bombardment device 5 to perform a vapour-phase physical deposition process of a thin layer on a substrate 3, as depicted in figure 8, so that a target like the one depicted in figure 9c can be obtained;

d) Remove the resin mask 6, i.e. by dissolution, in order to obtain the product depicted in figure 9d;

e) Measure the local height differences between target 2 resin covered points and non resin covered points 7, which is possible using the target depited in figure 9d;

f) Obtain an engraving velocity function $v_j(x_i, y_i)$ of the target (2) for the aforementioned certain conditions;

g) Use the said engraving velocity function $v_j(x_i, y_i)$ to determine the thickness $(e_j(x_i, y_i))$ of the target in every position $(x,y)$ so that the layer or layers $(j)$ of the fungible element can be consumed one after another.

An optical process with similar results can be performed following the stages of:

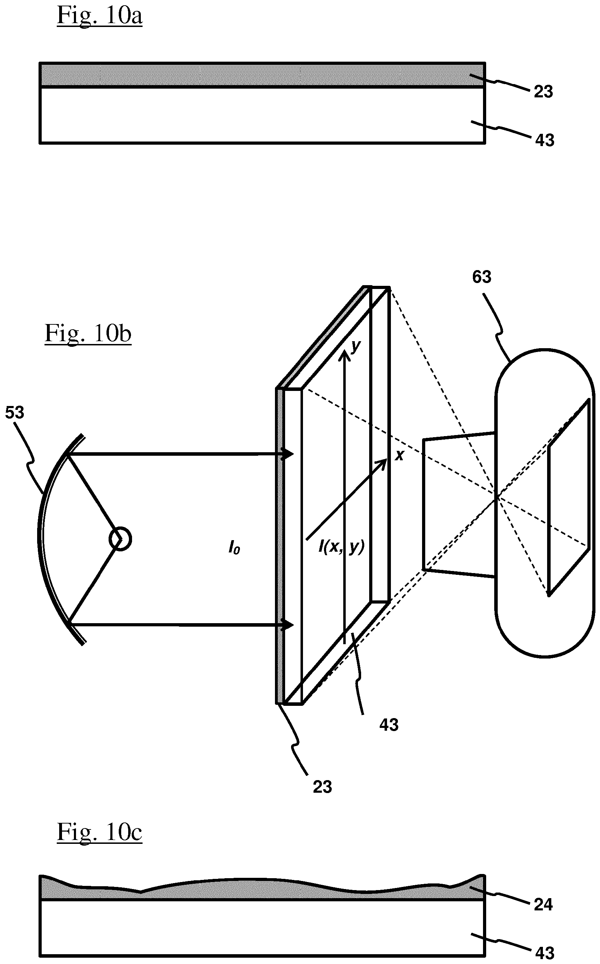

a) Perform a deposition, distinguished by a certain optical absorption, $\alpha(\lambda)$, where $\lambda$ is the wavelength, over a transparent base layer 43 in order to obtain an homogeneous thickness target 23, distinguished by a certain optical absorption, $\alpha(\lambda)$, as depicted in figure 10a;

b) Dispose the transparent base layer 43 with the homogeneous thickness target 23, distinguished by a certain optical absorption, $\alpha(\lambda)$, in an $I_0$ intensity, normal incidence illumination device with a lamp 53, i.e. with white light or monochromatic light of $I_0$ intensity, as depicted in figure 10b;

c) Obtain a photographic image by means of a photographic device 63, of the posterior part of the system integrated by the transparent base 43 and the homogeneous thickness target 23 and $\alpha(\lambda)$ optical absorption, when crossed by an incident light beam of $I_0$ intensity, which is partially absorbed according to Alambert law:

$$I(x,y) = I_0 \cdot \exp[-\alpha \cdot e(x,y)]$$

where I(x,y) is the intensity of the light transmitted by the system integrated by the transparent base 43 and the homogeneous thickness target 23 and $\alpha(\lambda)$ optical absorption, where the variables $(x, y)$ are the target 23 coordinates, and $e(x,y)$ the thickness of the target 23 in every position after the sputtering by particle bombardment;

d) Dispose the product obtained in a) during a certain amount of time, in a certain position and in front of a certain particle bombardment device 5 to carry out the vapour-phase physical deposition of a thin layer on a substrate 3, as shown in figure 8, in such a way that a target like the one depicted in figure 9c is obtained;

e) Determine the relation $IF(x,y)/IF_0(x,y)$ point by point, of the given intensity in every pixel of the target 2 photographic images, before, $IF_0(x,y)$, and after, $IF(x,y)$, the particle bombardment by sputtering, performed for example by means of image treatment common techniques as well as techniques of matrix calculation using the image pixels as matrix elements.

f) Assuming the linearity of the photographic image collected intensities regarding the light beam intensity:

$$IF(x,y) = k \cdot I(x,y)$$

where k is a constant, in order to determine the target 24 thickness after being sputtered by the particle bombardment, based on position (x,y) using the expression:

$$e(x,y) = \frac{1}{\alpha} \ln \frac{IF_0(x,y)}{IF(x,y)}$$

g) Obtain an engraving velocity function $v(x, y)$ for the target 24 for the aforementioned certain conditions;

h) Use the engraving velocity function $v(x, y)$ to determine the thickness $e(x, y)$ of every target position $(x,y)$ so that the layer or layers of the fungible element can be consumed one after another.

i) Utilize image treatment software for, by means of the appropriate filters and the obtained thickness function $e(x, y)$, and generate constant thickness domains $D_i, e_j(x_i, y_i)$ and arbitrary dimensions, that cover the target 24 surface.

These processes can be performed in a systematic way, that is they can easily become a protocol or even be automated.

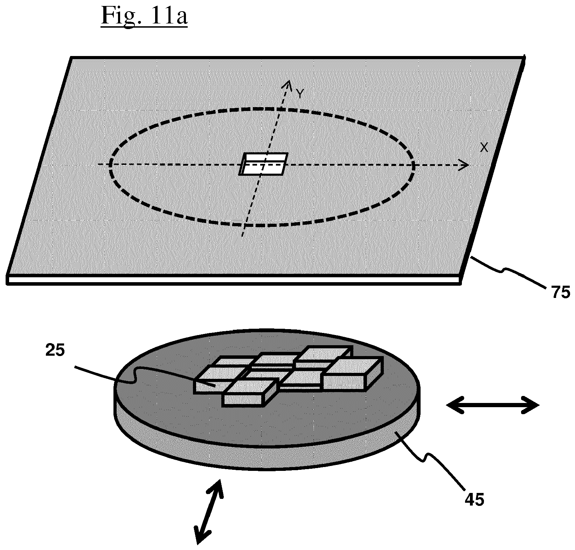

The invention also refers to a process to fabricate the fungible element 1, after the determination of the engraving velocity $v_i(x_i,y_i)$, by means of physical vapour deposition (PVD) techniques or chemical vapour deposition (CVD) techniques, to obtain monolayer or multilayer structures on a base layer 45, as shown in figure 11a, which comprises the stages of:

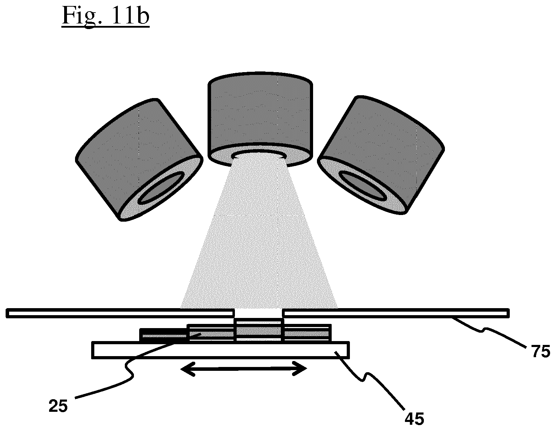

a) Perform a PVD or CVD deposition using a mask 75, with a $D_i$ domain sized aperture, attached on a base layer 45, with adjustable $(x, y)$ position, in order to obtain a monolayer or multilayer target 25 with $e_j(x_i, y_i)$ thickness domains, as shown in figure 11b;

b) Perform the material deposition in order to obtain a monolayer or multilayer target 25 by means of PVD or CVD process, using a mask 75 attached to the base layer 45, sequentially by moving the base 45 over every $D_i$ domain, and keeping on the deposition process over every $D_i$ domain during a $\tau_{ij}(x_i, y_i)$, time period, determined by the following expression:

$$\tau_{ij}(x_i, y_i) = P_{ij} M_{ij} L_{ij} \frac{e_i(x_i, y_i)}{v_i(x_i, y_i)}$$

where $Pi_j, M_{ij}$ y $L_{ij}$ are constants determined respectively by the type of material deposited on each layer of the target 25 multilayer system, by the PVD or CVD process conditions of each layer of the target 25 multilayer system and the final thicknesses of each desired material layer and the initial thickness obtained during the process of determination of the particle bombardment engraving pattern, where the subscripts i and j indicate respectively the domain and the multilayer system layer number to be obtained for the target 25 fabrication.

c) For the calculation of the constants $P_{ij}, M_{ij}$ y $L_{ij}$, a PVD or CVD deposition velocity calibration process is performed for each material to be used.

The invention is not limited to the specific embodiments previously described but also comprises, for example, the variants that can be performed by the skilled person, always remaining within the scope of the claims.

**Claims**

1.  The invention relates to a fungible element (1) provided with a target (2) for the particle bombardment, intended to carry out the vapour-phase physical deposition of a thin layer on a substrate (3), said fungible element (1) comprising a base layer (4) on which the target (2) is deposited, said target intended to be sputtered by the particle bombardment, **wherein** the target is formed by at least one layer (21) in which a plurality of zones $(x_i, y_i)$ is defined, having an average thickness $(e_j(x_i, y_i))$ that is variable between the zones $(x_i, y_i)$, said average thicknesses $(e_j(x_i, y_i))$ of each zone $(x_i, y_i)$ being dimensioned such that, in certain bombardment conditions, all the zones $(x_i, y_i)$ have an identical ion sputtering time $(t_j)$.

2.  Element, according to claim number 1, wherein the target is constituted by a plurality of layers (21, 22).

3.  The element different zones $(x_i, y_i)$, according to any of the previous claims, can be composed by the same material as well as by different materials.

4.  Set formed by particle bombardment device (5) and fungible element (1) provided with a target (2) to be bombarded by the particle bombardment device (5) to perform vapour-phase physical deposition of a thin layer on a substrate (3) bound to receive the deposition material disposed on the target (2), said fungible element (1) comprising a base layer (4) on which said target (2) is deposited, **wherein** said target (2) is constituted by at least one layer (21) in which a plurality of zones $(x_i, y_i)$ with an average thickness $(e_j(x_i, y_i))$ that is variable between the zones $(x_i, y_i)$, said average thicknesses $(e_j(x_i, y_i))$ of each zone $(x_i, y_i)$ being dimensioned such that, in certain bombardment conditions, all the zones $(x_i, y_i)$ have an identical ion sputtering time $(t_j)$, being so that the thickness of the layer deposited on said substrate (3) can be controlled by the previous sizing of the target (2) deposition material thicknesses $(e_j(x_i, y_i))$.

5.  Said set, according to claim number 1, wherein the target is constituted by a plurality of layers (21, 22).

6.  Said set, according to any of claims 4 and 5, in its different zones $(x_i, y_i)$ can be composed by the same material as well as by different materials.

7.  Said set, according to any of claims 4 to 6, in which the bombardment is an ionic bombardment performed by means of a cathodic sputtering head or a plasma ion gun as well as a bombardment of neutral particles by means of a neutralized ion gun or a plasma gun.

8.  Said set, according to any of claims 4 to 6, in which the bombardment is a photonic bombardment in order to produce laser ablation (LAD) or photonic bombardment by means of pulsed laser (PLD).

9.  Said set, according to claim number 7, in which the head or gun comprises the means for changing its orientation so it is possible to orient it towards the target as well as the substrate, thus having the possibility of commuting between an ion or plasma gun assisted deposition mode and a compaction by direct bombardment mode.

10. Process for the determination of an engraving pattern by target (2) particles bombardment, in order to obtain an engraving velocity and thickness $(e_j(x_i, y_i))$ based on the position $(x, y)$ of a fungible element (1) according to any of claims 1 to 3, comprising the stages of:

    a) Perform an homogeneous deposit of deposition material on a base layer (4) to obtain an homogeneous thickness target (2);
    b) Dispose on the target (2) a resin mask (6), so that there are zones of the target (2) that remain covered by the resin as well as zones that remain uncovered by the resin (7);
    c) Dispose the resulting product during a certain amount of time, in a certain position and in front of a certain particle bombardment device (5) to perform a vapour-phase physical deposition process of a thin layer on a substrate (3);
    d) Remove the resin mask (6);
    e) Measure the local height differences between target (2) resin covered points and non resin covered points (7);
    f) Obtain an engraving velocity function $v_j(x_i, y_i)$ of the target (2) for the aforementioned certain conditions;
    g) Use the said engraving velocity function $v_j(x_i, y_i)$ to determine the thickness $(e_j(x_i, y_i))$ of the target in every position $(x, y)$ so that the layer or layers $(j)$ of the fungible element can be consumed one after another.

11. Process according to claim number 10, in which the mask (7) is a mesh.

12. Process for the determination of the pattern by target (2) particles bombardment, for the obtaining of the engraving velocity and thickness $(e_j(x_i, y))$ based on the position $(x, y)$ of a fungible element (1) according to any of claims 1 to 3, comprising the stages of:

a) Perform a deposition, distinguished by a certain optical absorption, $\alpha(\lambda)$, where $\lambda$ is the wavelength, over a transparent base layer (43) in order to obtain an homogeneous thickness target (23), distinguished by a certain optical absorption, $\alpha(\lambda)$;

b) Dispose the transparent base layer (43) with the homogeneous thickness target (23), distinguished by a certain optical absorption, $\alpha(\lambda)$, in an $I_0$ intensity, normal incidence illumination device with a lamp (53);

c) Obtain a photographic image by means of a photographic device (63), of the posterior part of the system integrated by the transparent base (43) and the homogeneous thickness target (23) and $\alpha(\lambda)$ optical absorption, when crossed by an incident light beam of $I_0$ intensity, which is partially absorbed according to Alambert law:

$$I(x,y) = I_0 \cdot \exp[-\alpha \cdot e(x,y)]$$

where I(x,y) is the intensity of the light transmitted by the system integrated by the transparent base (43) and the homogeneous thickness target (23) and $\alpha(\lambda)$ optical absorption, where the variables $(x, y)$ are the target (23) coordinates, and $e(x,y)$ the thickness of the target (23) in every position after the sputtering by particle bombardment;

d) Dispose the product obtained in a) during a certain amount of time, in a certain position and in front of a certain particle bombardment device (5) to carry out the vapour-phase physical deposition of a thin layer on a substrate (3);

e) Determine the relation $IF(x,y)/IF_0(x,y)$ point by point, of the given intensity in every pixel of the target (2) photographic images, before, $IF_0(x,y)$, and after, $IF(x,y)$, the particle bombardment by sputtering.

f) Assume the linearity of the photographic image collected intensities regarding the light beam intensity:

$$IF(x,y) = k \cdot I(x,y)$$

where k is a constant, in order to determine the target (24) thickness after being sputtered by the particle bombardment, based on position (x, y) using the expression:

$$e(x,y) = \frac{1}{\alpha} \ln \frac{IF_0(x,y)}{IF(x,y)}$$

g) Obtain an engraving velocity function $v(x, y)$ for the target (24) for the aforementioned certain conditions;

h) Use the engraving velocity function $v(x, y)$ to determine the thickness $e(x, y)$ of every target position $(x,y)$ so that the layer or layers of the fungible element can be consumed one after another.

i) Utilize image treatment software for, by means of the appropriate filters and the obtained thickness function $e(x, y)$, and generate constant thickness domains $D_i$, $e_j(x_i, y_i)$ and arbitrary dimensions, that cover the target (24) surface.

13. Process, according to claim number 12, in which the deposition of stage a) is homogeneous and formed by a semitransparent deposition material.

14. Process, according to claim 13, in which the deposition is a very thin metal layer of about some tens of nanometers, as well as a semitransparent material with a non null optical transmittance specter, such as a semiconductor material, or a semitransparent dielectric.

15. Process, according to claims 12 to 14, in which the stage b) is performed with white light or monochromatic light of $I_0$ intensity.

16. Process, according to any claim from 1 to 15, in which stage e) is performed by means of image treatment common techniques as well as techniques of matrix calculation using the image pixels as matrix elements.

17. Process to fabricate the fungible element (1), after the determination of the engraving velocity $v_i(x_i, y_i)$, by means of physical vapour deposition (PVD) techniques or chemical vapour deposition (CVD) techniques, to obtain monolayer or multilayer structures on a base layer (45), which comprises the stages of:

a) Perform a PVD or CVD deposition using a mask (75), with a $D_i$ domain sized aperture, attached on a base layer (45), with adjustable $(x, y)$ position, in order to obtain a monolayer or multilayer target (25) with $e_j(x_i, y_i)$ thickness domains;

b) Perform the material deposition in order to obtain a monolayer or multilayer target (25) by means of PVD or CVD process, using a mask (75) attached to the base layer (45), sequentially by moving the base (45) over every $D_i$ domain, and keeping on the deposition process over every $D_i$ domain during a $\tau_{ij}(x_i, y_i)$, time period, determined by the following expression:

$$\tau_{ij}(x_i, y_i) = P_{ij} M_{ij} L_{ij} \frac{e_i(x_i, y_i)}{v_i(x_i, y_i)}$$

where $P_{ij}$, $M_{ij}$ y $L_{ij}$ are constants determined respectively by the type of material deposited on each layer of the target (25) multilayer system, by the PVD or CVD process conditions of each layer of the target (25) multilayer system and the final thicknesses of each desired material layer and the initial thickness obtained during the process of determination of the particle bombardment engraving pattern, where the subscripts i and *j* indicate respectively the domain and the multilayer system layer number to be obtained for the target (25) fabrication.

18. Process, according to claim number 17, in which the mask (75) is formed by a rigid material, preferably metallic.

19. Process, according to claim 17 or 18, in which a single process or a repetitive process is performed in the stage b).

20. Process, according to any of the claims 17 to 19, in which for the calculation of the constants $P_{ij}$, $M_{ij}$ y $L_{ij}$, a PVD or CVD deposition velocity calibration process is performed for each material to be used.

Fig. 1

Fig. 2

Fig. 3

Fig. 4

Fig. 5

Fig. 6

Fig. 7

Fig. 8

Fig. 9a

2

4

Fig. 9b

7

Fig. 9c

Fig. 9d

## Fig. 10a

— 23
— 43

## Fig. 10b

$I_0$

$I(x, y)$

$x$

$y$

53

63

43

23

## Fig. 10c

— 24
— 43

Fig. 11a

Fig. 11b

# INTERNATIONAL SEARCH REPORT

| International application No. |
| --- |
| PCT/ES2016/070220 |

## A. CLASSIFICATION OF SUBJECT MATTER

***C23C14/34*** (2006.01)
***C23C14/28*** (2006.01)
According to International Patent Classification (IPC) or to both national classification and IPC

## B. FIELDS SEARCHED

Minimum documentation searched (classification system followed by classification symbols)
C23C

Documentation searched other than minimum documentation to the extent that such documents are included in the fields searched

Electronic data base consulted during the international search (name of data base and, where practicable, search terms used)

EPODOC, INVENES, WPI, TXT, XPESP

## C. DOCUMENTS CONSIDERED TO BE RELEVANT

| Category* | Citation of document, with indication, where appropriate, of the relevant passages | Relevant to claim No. |
| --- | --- | --- |
| X | US 2003165639 A1 (PARK JAE YEOL) 04/09/2003, paragraphs [0022 - 0044]; figures 4 - 5. | 1-9 |
| X | US 2004050689 A1 (VOSER STEPHAN ET AL.) 18/03/2004, abstract; paragraphs [0025 - 0032]; figures 3 - 5. | 1-9 |
| X | WO 2014107558 A1 (TOSOH SMD INC) 10/07/2014, paragraphs [0008 - 0039]; figure 1. | 1-9 |
| A | WO 2010085685 A2 (NOVELLUS SYSTEMS INC ET AL.) 29/07/2010, figure 8, paragraphs [0023 - 0027]. | 1-20 |

☒ Further documents are listed in the continuation of Box C.       ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means. | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | "&" document member of the same patent family |

| Date of the actual completion of the international search | Date of mailing of the international search report |
| --- | --- |
| 18/05/2016 | **(20/05/2016)** |
| Name and mailing address of the ISA/ <br><br> OFICINA ESPAÑOLA DE PATENTES Y MARCAS <br> Paseo de la Castellana, 75 - 28071 Madrid (España) <br> Facsimile No.: 91 349 53 04 | Authorized officer <br> M. García Poza <br><br> Telephone No. 91 3495568 |

Form PCT/ISA/210 (second sheet) (January 2015)

**EP 3 279 365 A1**

## INTERNATIONAL SEARCH REPORT

| | International application No. |
|---|---|
| | PCT/ES2016/070220 |

| C (continuation). | DOCUMENTS CONSIDERED TO BE RELEVANT | |
|---|---|---|
| Category * | Citation of documents, with indication, where appropriate, of the relevant passages | Relevant to claim No. |
| A | WO 2009086038 A1 (INFINITE POWER SOLUTIONS INC  ET AL.) 09/07/2009, figures 1 - 4. Paragraphs [0036 - 0039]. | 1-20 |

Form PCT/ISA/210 (continuation of second sheet) (January 2015)

16

## INTERNATIONAL SEARCH REPORT

Information on patent family members

| International application No. |
| --- |
| PCT/ES2016/070220 |

| Patent document cited in the search report | Publication date | Patent family member(s) | Publication date |
| --- | --- | --- | --- |
| US2003165639 A1 | 04.09.2003 | US2005045470 A1 | 03.03.2005 |
| | | US6824652 B2 | 30.11.2004 |
| | | KR20030071926 A | 13.09.2003 |
| US2004050689 A1 | 18.03.2004 | JP2010013737 A | 21.01.2010 |
| | | US6916407 B2 | 12.07.2005 |
| | | TWI252873B B | 11.04.2006 |
| | | JP2004514066 A | 13.05.2004 |
| | | EP1341948 A1 | 10.09.2003 |
| | | WO0242518 A1 | 30.05.2002 |
| WO2014107558 A1 | 10.07.2014 | JP2016507651 A | 10.03.2016 |
| | | US2015357169 A1 | 10.12.2015 |
| | | CN105008582 A | 28.10.2015 |
| | | KR20150101470 A | 03.09.2015 |
| | | TW201435117 A | 16.09.2014 |
| WO2010085685 A2 | 29.07.2010 | US2010187693 A1 | 29.07.2010 |
| | | US8053861 B2 | 08.11.2011 |
| WO2009086038 A1 | 09.07.2009 | KR20150128817 A | 18.11.2015 |
| | | TW200944608 A | 01.11.2009 |
| | | TWI441937B B | 21.06.2014 |
| | | JP2011509502 A | 24.03.2011 |
| | | JP5551612B B2 | 16.07.2014 |
| | | CN101903560 A | 01.12.2010 |
| | | CN101903560B B | 06.08.2014 |
| | | KR20100102180 A | 20.09.2010 |
| | | EP2225406 A1 | 08.09.2010 |
| | | EP2225406 A4 | 05.12.2012 |
| | | US2009162755 A1 | 25.06.2009 |
| | | US8268488 B2 | 18.09.2012 |
| | | US2009159433 A1 | 25.06.2009 |